# EUROPEAN PATENT SPECIFICATION

(11) **EP 2 347 643 B1**
(45) Date of publication and mention of the grant of the patent: **20.03.2013**
(21) Application number: 09748360.6
(22) Date of filing: 01.10.2009
(51) Int. Cl.: H05K 7/20

(54) **COOLING STRUCTURE FOR ELECTRONIC DEVICE, AND A METHOD**
KÜHLSTRUKTUR FÜR EINE ELEKTRONISCHE ANORDNUNG UND VERFAHREN
STRUCTURE DE REFROIDISSEMENT POUR UN DISPOSITIF ÉLECTRONIQUE ET PROCÉDÉ

(30) Priority: 08.10.2008 FI 20085945
(43) Date of publication of application: 27.07.2011
(73) Proprietor: ABB OY, 00380 Helsinki (FI)
(72) Inventor: SMALEN, Matti, 01840 Klaukkala (FI); KOIVULUOMA, Timo, 01710 Vantaa (FI); LAITINEN, Matti, 02400 Kirkkonummi (FI)
(74) Representative: Holmström, Stefan Mikael
(86) International application number: PCT/FI2009/050792
(87) International publication number: WO 2010/040896

(56) References cited:
- EP-A1- 1 885 169
- EP-A2- 0 356 991
- DE-U1-202004 015 168
- GB-A- 2 369 249
- US-A1- 2007 064 390
- US-A1- 2007 215 329

## Description

### FIELD OF THE INVENTION

The present invention relates to a cooling structure for an electronic device and, in particular, to a solution preventing dirt particles from proceeding to electronic components.

### DESCRIPTION OF PRIOR ART

In locations where the environment of an electronic device comprises large amounts of dirt particles, implementation of a cooling flow is to make sure that particles affecting the operation and reliability of the electronic device are not allowed to proceed to electronic components.

In prior art solutions, as disclosed for example in GB 2 369 249 or in DE 20 2004 015 168 U, the flow is conveyed through one or more filters before the filtered flow is allowed to proceed to the electronic components. A problem is then the fouling of the filter and a resulting need to change the filter at intervals. In view of the costs, it is desirable that the filters would not need replacement at all or at least that the replacement interval would be as long as possible.

### SUMMARY OF THE INVENTION

The object of the present invention is to solve the above-described problem and provide a solution whereby it is possible to reduce considerably the amount of dirt particles finding their way to electronic components of an electronic device. This is achieved by a cooling structure in accordance with independent claim 1 and a method in accordance with independent claim 10.

In the invention, the flow is divided into at least two branches. The main flow is allowed to proceed in a first flow direction into a first flow channel, where dirt particles, if any, contained in the flow are not able to cause significant harm. From the main flow a flow that is secondary to the main flow is separated into a second flow channel by a port that is oriented transversely to the first flow direction or away from the first flow direction. Thanks to said arrangement the largest and heaviest dirt particles continue to proceed in the first flow direction past the port. The flow entering the second flow channel is first conveyed into an intermediate space and only thereafter into a component space, whereby the flow ending up to the component space is considerably cleaner than the flow ending up in the first flow channel.

In the invention, the surface area of a port through which the flow in the second flow channel enters an intermediate space is smaller than the surface area of an opening in a partition wall between the intermediate space and the component space, through which the flow passes from the intermediate space into the component space of the second flow channel. So the flow rate decreases in the intermediate space. Hence, because of the low flow rate the flow does no longer carry the dirt particles along with the flow from the intermediate space onwards, but they will remain in the intermediate space. The flow reaching the electronic components is thus cleaner than before and the dirt particles accumulated in the intermediate space can be subsequently removed from the intermediate space, for instance in connection with maintenance.

It should be noted that even though this application refers to a port and an opening in a partition wall, the openings in question may be multi-sectional, i.e. instead of one large opening they may consist of several smaller openings.

The preferred embodiments of the cooling structure and the method in accordance with the invention are disclosed in the attached dependent claims 2 to 9.

### BRIEF DESCRIPTION OF THE DRAWINGS

In the following the invention will be described in greater detail, by way of example, with reference to the attached drawings, in which
Figure 1 illustrates a first preferred embodiment of the cooling structure and the method in accordance with the invention,
Figure 2 illustrates a second preferred embodiment of the cooling structure in accordance with the invention,
Figures 3 and 4 illustrate a guide that may be utilized in the embodiment of Figure 2,
Figure 5 illustrates a third preferred embodiment of the cooling structure in accordance with the invention,
Figure 6 illustrates a fourth preferred embodiment of the cooling structure in accordance with the invention,
Figure 7 illustrates a fifth preferred embodiment of the cooling structure in accordance with the invention, and
Figures 8 to 10 illustrate a flow of particles in the cooling structure.

### DESCRIPTION OF AT LEAST ONE EMBODIMENT

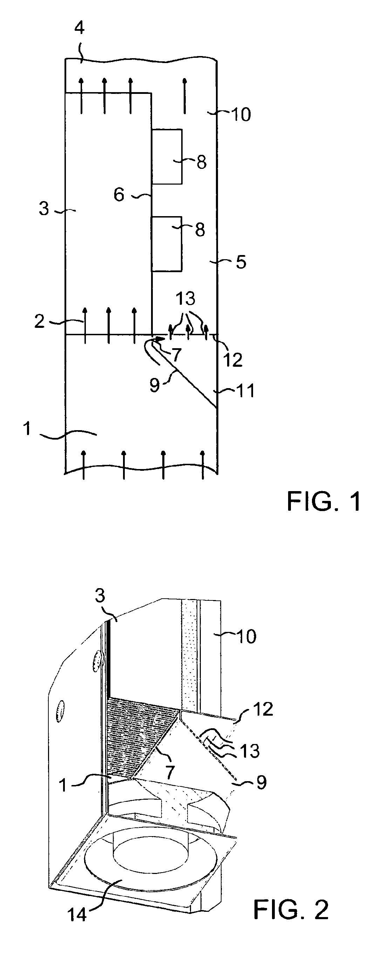

Figure 1 illustrates a first preferred embodiment of a cooling structure in accordance with the invention. The cooling structure of Figure 1 includes an inlet 1 for receiving an air flow, for instance, from a room space around an electronic device, and for conveying this air flow further in a first flow direction 2 towards a component 3 locating in a first flow channel. In the following it is assumed, by way of example, that the component 3 is a cooling element by means of which the air flow flowing in the first flow channel cools components in connection with the cooling element. If the electronic device in question is a frequency converter, for instance, it is possible to attach power semiconductors to be cooled to the cooling element.

The main flow flowing through the component 3 proceeds further from the first flow channel towards an outlet 4 of the cooling structure, through which the flowing air may return, for instance, to the room space around the electronic device.

The cooling structure of Figure 1 includes a second flow channel 5, which is separated from the first flow channel by a side plate 6 of the component 3 or, alternatively, a partition wall. In the case of Figure 1, the second flow channel 5 starts from a port 7 that is transverse to the first flow direction 2 and located in the upstream of the first component 3 and it receives part of the flow from the inlet 1. In the second flow channel 5 there are arranged such electronic components 8 that should avoid fouling. If the electronic device in question is a frequency converter, for instance, it is possible to arrange capacitors and a choke in the second flow channel. In the embodiment of Figure 1 the second flow channel 5 rejoins the first flow channel to have the same outlet 4. In this solution, for instance, the flow resistance in the first flow channel affects the amount of flow ending up in the second flow channel. For instance, if the component 3 causes high flow resistance a larger portion of the flow ends up in the second channel than in the case where the component 3 causes lower flow resistance.

The port 7 arranged transversely to the first flow direction 2, i.e. the main flow, is advantageously designed such that its width is relatively small in the first flow direction 2, and its length transverse to the first flow direction 2 exceeds the width. Because of the port 7 that is small in width the largest dirt particles are prevented from accessing the second flow channel 5 through the port due to their size. In addition, the orientation of the port 7 that is transverse to the first flow direction 2 results in the largest and heaviest particles continuing their course along with the main flow past the port 7 by the effect of their kinetic energy. The port may be oriented exactly transversely to the first flow direction, whereby the air flow diverts its course 90 degrees to pass through the port. An exact 90-degree diversion in course is not necessary, however, but the same result, i.e. the largest and heaviest dirt particles continue past the port 7 without ending up in the second flow channel, is achieved even though the diversion in course would not be exactly 90 degrees, but nearly 90 degrees or more. The orientation of this kind makes it possible to avoid that large and heavy dirt particles proceeding from the inlet along with the flow would hit the port directly.

In order to generate a flow the cooling structure of Figure 1 may include a fan in connection with the inlet 1. In that case the pressure provided by the fan generates a flow in the first and the second flow channels. Alternatively, there may be arranged a fan or fans in the first and/or the second flow channel after the first component 3 and the electronic component 8, respectively. In that case the partial vacuum generated by the fan or fans generates a flow in the first and the second flow channels.

In the embodiment of Figure 1, after the inlet 1 there is arranged a guide plate 9 in an oblique position to the first flow direction 2 so as to reduce the cross-sectional area of the flow from the inlet 1. The port 7 is arranged in the vicinity of the location where the cross-sectional area of the flow changes, in this example at the location where the change in the cross-sectional area ends, i.e. immediately after the guide plate 9. Because of the guide plate 9 a vortex is generated at the port. By the effect of centrifugal force the largest particles continue to proceed along the main flow to the first component 3 in the first flow channel and only the smallest and lightest particles enter the second flow channel 5.

In the embodiment of Figure 1, the second flow channel 5 includes a component space 10 and an intermediate space 11, which are separated from one another by a wall 12. The port 7, through which the flow is able to enter the second flow channel 5, may in an embodiment have a smaller surface area than the opening 13, through which the secondary flow in the second flow channel 5 is able to proceed from the intermediate space 11 to the component space 10. Consequently, the flow rate decreases in the intermediate space. Because of the lower flow rate the flow no longer carries dirt particles contained therein, but they remain in the intermediate space 11, wherefrom they may be subsequently removed, for instance in connection with maintenance. The flow ending up in the component space is thus still cleaner. The retention of dirt particles in the intermediate space will be enhanced, when the intermediate space has a turbulent air flow that enhances separation of dirt particles from the air flow.

Apart from the intermediate space 11 allowing adjustment of pressure loss in the second channel (by dimensioning of openings 7 and 13), the intermediate space may also be utilized as a location for a filter. In other words, if it is desired that the device also utilizes, for instance, a filter consisting of porous material or a cyclone, for instance, it is possible to arrange a filter of this kind in the intermediate space 11. In that case the replacement interval/cleaning interval may be longer than in the prior art solutions, because major part of dirt particles will never even reach the filter locating in the intermediate space.

It should be noted that even though this application refers to a port 7 and to an opening 13 in a partition wall, the openings in question may also be multi-sectional, i.e. instead of one large opening they may consist of several smaller openings. The opening 13 in the partition wall 12 makes it possible to affect how the flow disperses in the wide component space 10. The use of the multi-sectional opening 13, which thus consists of a plurality of smaller openings, allows the air flow to disperse efficiently throughout the whole width of the component space 10 at desired places (for instance, exactly at the electric components).

Figure 2 illustrates a second preferred embodiment of the cooling structure in accordance with the invention. The embodiment of Figure 2 corresponds to a great extent to the embodiment of Figure 1, and therefore it is described in the following primarily by highlighting the differences between these embodiments.

In the embodiment of Figure 2, in connection with an inlet 1 there is arranged a fan 14 that produces an air flow at the inlet 1. In this embodiment, as well, a first and a second flow channel are mainly parallel, i.e. a component space 10, which is located downstream of an intermediate space of the second flow channel, is parallel to the first flow channel housing a component 3. This is not necessary, however, in all embodiments. When the fan is located in connection with the inlet 1, the first and the second flow channels need not have a common outlet, but they may open up in the room space around the electronic device through different openings. Hence, they need not be mainly parallel either.

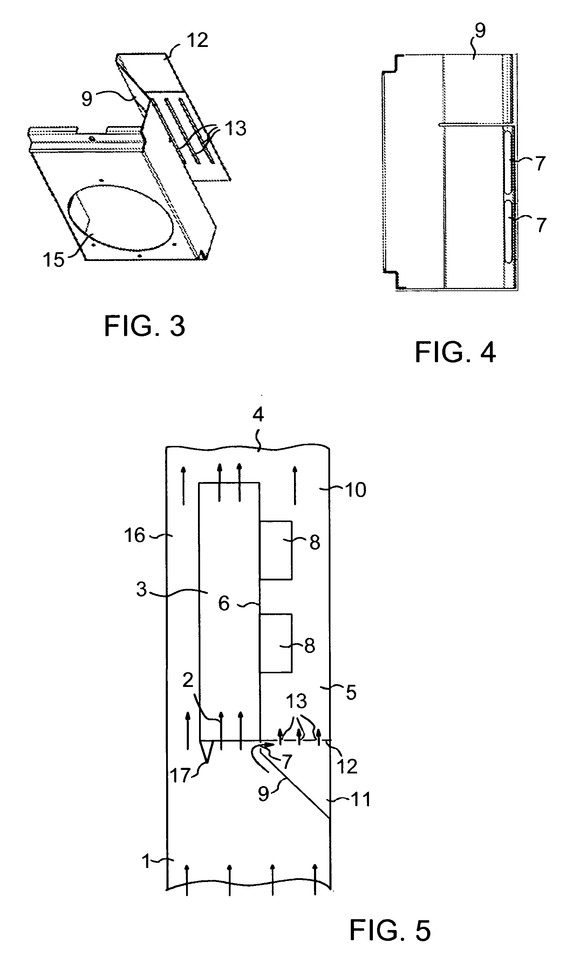

Figures 3 and 4 illustrate a guide that may be utilized in the embodiment of Figure 2. In Figure 3 the guide is seen obliquely from above, and in Figure 4 seen from the right of Figure 3.

The guide may be a part made of sheet metal, for instance, which forms the guide plate 9 and the partition wall 12 shown in Figure 2 and which comprises an opening 15 for the fan. It appears from Figure 4 that the port 7, through which the flow enters the second flow channel, is multi-sectional, i.e. it comprises two narrow yet long (vertical length in Figure 4) gaps. Correspondingly, it appears from Figure 3 that also the opening 13, through which the flow passes from the intermediate space 11 to the component space 10, is multi-sectional. In this example the opening 13 consists of three parallel gaps, the total surface area of which is larger than the total surface area of the multi-sectional port 7.

Figure 5 illustrates a third preferred embodiment of the cooling structure in accordance with the invention. The embodiment of Figure 5 corresponds to a great extent to the embodiment of Figure 1, and therefore it is described in the following primarily by highlighting the differences between these embodiments.

In the embodiment of Figure 5 the cooling structure further includes a third flow channel 16, which in this example is parallel to the first flow channel and the second flow channel 5. The third flow channel may be utilized for conveying an air flow to other components to be cooled than the cooling element 3 and the electronic components 8.

In the embodiment of Figure 5, in the component 3 there is also arranged a guide 17, which contributes to distribution of the flow between the first, the second and the third flow channels.

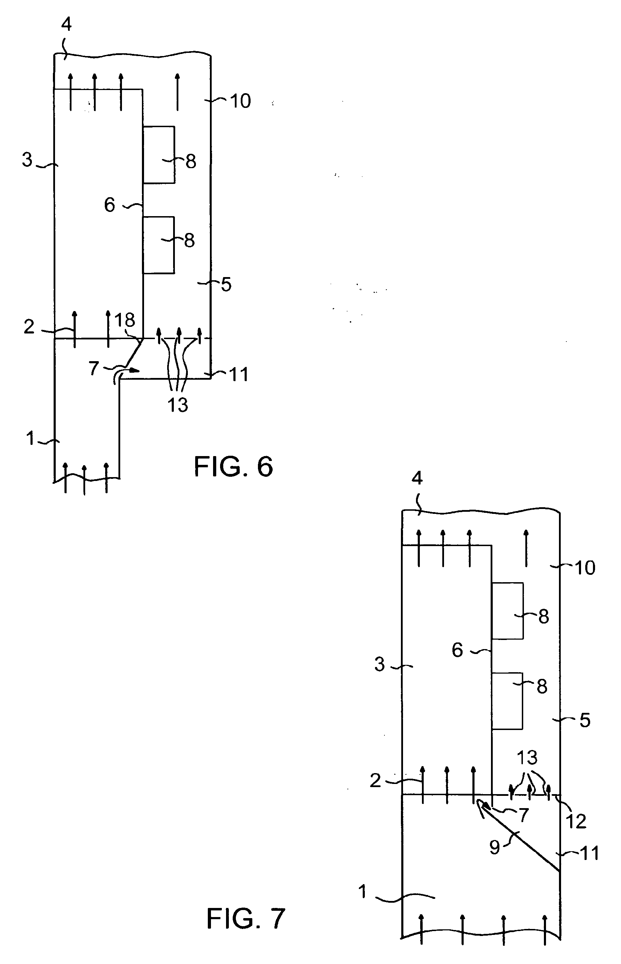

Figure 6 illustrates a fourth preferred embodiment of the cooling structure in accordance with the invention. The embodiment of Figure 6 corresponds to a great extent to the embodiment of Figure 1, and therefore it is described in the following primarily by highlighting the differences between these embodiments.

In the embodiment of Figure 6, as well, the port 7 is arranged in the vicinity of the point where the cross-sectional area of the flow from the inlet changes. Unlike in the preceding embodiments, the port 7 is, however, at the location where the cross sectional area of the flow increases due to an oblique wall 18. Also in a solution of this kind the largest and heaviest dirt particles continue to proceed in the first flow direction due to their kinetic energy, whereby a cleaner flow enters the intermediate space 11.

Figure 7 illustrates a fifth preferred embodiment of the cooling structure in accordance with the invention. The embodiment of Figure 7 corresponds to a great extent to the embodiment of Figure 1, and therefore it is described in the following primarily by highlighting the differences between these embodiments.

In the case of Figure 7 the port 7 is not transverse to the first flow direction 2, but it is oriented still further away from the first flow direction. In this embodiment the air from the inlet 1 is to divert considerably more than 90 degrees to enter the intermediate space through the port 7.

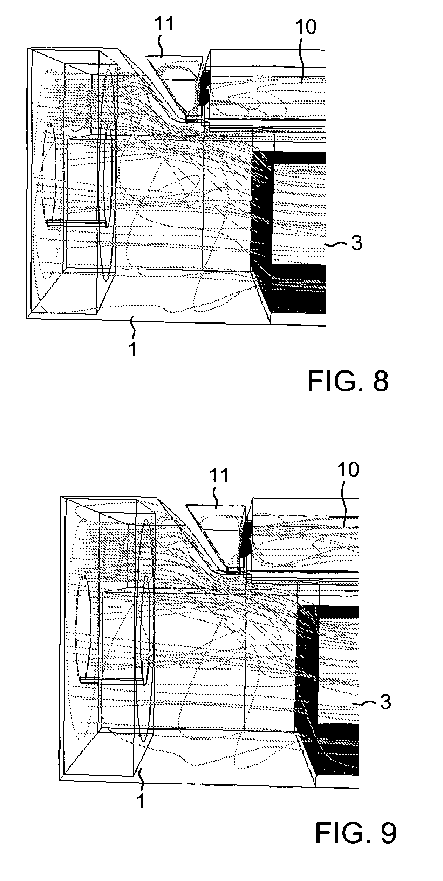

Figures 8 to 10 illustrate flow of particles in the cooling structure. Figures 8 to 10 simulate flow of ashes in the cooling structure of Figure 2 by using particles of various sizes and by maintaining the conditions unchanged.

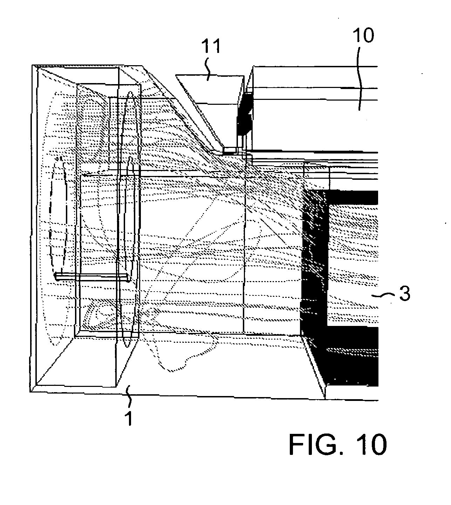

In the case of Figure 8 the diameter of the particles is 1 µm, in the case of Figure 9 the diameter of the particles is 10 µm and in the case of Figure 10 the diameter of the particles is 20 µm. When Figures 8 to 10 are compared with one another, it is observed that some of the smallest particles (Figure 8) pass through the intermediate space 11 to the component space 10, but as the particle size increases, less particles will end up in the component space 10 (Figure 9). The particle size being largest (Figure 10), particles will no longer reach the component space 10. Thus, the structure manages to filter out the largest and most harmful particles from the flow to be conveyed to the component space.

## Claims

1. A cooling structure for an electronic device, the structure including
an inlet (1) for receiving and conveying a flow further in a first flow direction (2) towards a first component (3) located in a first flow channel,
an outlet (4) for conveying the flow further from the first component (3) located in the first flow channel and
a second flow channel (5), which starts from a port (7) oriented transversely to the first flow direction (2) or away from the first flow direction (2), which is located in the flow upstream of the first component (3) and receives part of the flow from the inlet (1) and which conveys said part of the flow to an electronic component (8) located in the second flow channel (5), **characterized in that**
the second flow channel (5) includes an intermediate space (11) and a component space (10) separated from one another by a partition wall (12),
the intermediate space (11) located at the beginning of the second flow channel (5) communicates with the component space (10) through an opening (13) in the partition wall (12), and
the surface area of the port (7), through which the flow enters the intermediate space (11) is smaller than the surface area of the opening (13) in the partition wall (12), through which the flow passes from the intermediate space (11) into the component space (10).

2. The cooling structure of claim 1, **characterized in that**
the second flow channel (5) is mainly parallel to the first flow channel and that
the first and the second flow channels have a common outlet (4) for conveying the flow further from the first and the second flow channels.

3. The cooling structure of any one of claims 1 to 2, **characterized in that** the port (7), wherefrom the second flow channel (5) starts, is located in the vicinity of a point where the cross-sectional area of the flow from the inlet changes.

4. The cooling structure of claim 3, **characterized in that** the port (7), wherefrom the second flow channel (5) starts, is located at a location where the reduction in cross-sectional surface area of the flow from the inlet (1) ends.

5. The cooling structure of any one of claims 1 to 2, **characterized in that**
the cooling structure includes a guide plate (9) that is arranged in an oblique position to the first flow direction (2) so as to reduce the cross-sectional area of the flow from the inlet (1), and that
the port (7), wherefrom the second flow channel (5) starts, is arranged immediately downstream of the guide plate (9).

6. The cooling structure of any one of claims 1 to 5, **characterized in that** the first component (3) is a cooling element, by means of which the flow cools electronic components in connection with the cooling element (3).

7. The cooling structure of any one of claims 1 to 6, **characterized in that** in connection with the inlet (1) there is arranged a fan (14) for generating said flow.

8. The cooling structure of any one of claims 1 to 6, **characterized in that** the cooling structure includes one or more fans (14) arranged downstream of the first component (3) in the first flow channel and the electronic component (8) in the second flow channel (5), respectively, so as to generate a flow in the first and the second flow channels.

9. The cooling structure of any one of claims 1 to 8, **characterized in that** the port (7), wherefrom the second flow channel (5) starts, has a first width in the first flow direction (2) that is smaller than the length of the port (7) transverse to the first flow direction (2).

10. A method for providing a cooling flow for an electronic component, the method
separating a secondary flow from a main flow with a port (7) oriented transversely to the first flow direction (2) or away from the first flow direction and
conveying the separated secondary flow through a component space (10) housing an electronic component (8) to an outlet (4), **characterized in that** said secondary flow is conveyed into the component space (10) through an intermediate space (11), the component space being separated from the intermediate space by a partition wall (12), and
reducing the flow rate of the secondary flow in the intermediate space (11) located upstream of the component space (10) by conveying the secondary flow into the intermediate space through a port (7) whose surface area is smaller than the surface area of an opening (13) through which the secondary flow is conveyed further from the intermediate space (11) to the component space (10).

## Patentansprüche

1. Eine Kühlstruktur für eine elektronische Vorrichtung, wobei die Struktur Folgendes aufweist
einen Einlass (1) zum Empfangen und zum Weiterbefördern eines Flusses in eine erste Fließrichtung (2) in Richtung auf eine erste, in einem ersten Fließkanal befindliche Komponente (3),
einen Auslass (4) zum Weiterbefördern des Flusses von der ersten, in dem ersten Fließkanal befindlichen Komponente (3) und
einen zweiten Fließkanal (5), der von einer Pforte (7) beginnt, die quer zur ersten Fließrichtung (2) oder von der ersten Fließrichtung (2) wegwärts orientiert ist, die sich in dem Fluss flussaufwärts von der ersten Komponente (3) befindet und einen Teil des Flusses von dem Einlass (1) erhält und den besagten Teil des Flusses an eine elektronische Komponente (8) befördert, die sich in dem zweiten Fließkanal (5) befindet, **dadurch gekennzeichnet, dass**
der zweite Fließkanal (5) einen Zwischenraum (11) und einen Komponentenraum (10) aufweist, welche durch eine Trennwand (12) voneinander separiert sind,
der Zwischenraum (11), welcher sich am Anfang des zweiten Fließkanals (5) befindet, mit dem Komponentenraum (10) durch eine Öffnung (13) in der Trennwand (12) in Verbindung steht, und
der Flächeninhalt der Pforte (7), durch welche der Fluss in den Zwischenraum (11) eintritt, kleiner als der Flächeninhalt der Öffnung (13) in der Trennwand (12) ist, durch welche der Fluss aus dem Zwischenraum (11) in den Komponentenraum (10) durchfließt.

2. Die Kühlstruktur gemäß dem Patentanspruch 1, **dadurch gekennzeichnet, dass**
der zweite Fließkanal (5) hauptsächlich parallel zu dem ersten Fließkanal verläuft und
der erste und der zweite Fließkanal einen gemeinsamen Auslass (4) zum Weiterbefördern des Flusses von dem ersten und dem zweiten Fließkanal aufweisen.

3. Die Kühlstruktur gemäß einem der Patentansprüche 1 bis 2, **dadurch gekennzeichnet , dass** sich die Pforte (7), von welcher der zweite Fließkanal (5) beginnt, in der Nähe eines Punktes befindet, wo sich der Querschnittsbereich des Flusses aus dem Einlass verändert.

4. Die Kühlstruktur gemäß dem Patentanspruch 3, **dadurch gekennzeichnet, dass** die Pforte (7), von welcher der zweite Fließkanal (5) beginnt, sich an einem Platz befindet, wo die Reduktion des Querschnittflächeninhalts des Flusses aus dem Einlass (1) endet.

5. Die Kühlstruktur gemäß einem der Patentansprüche 1 bis 2, **dadurch gekennzeichnet, dass**
die Kühlstruktur eine Führungsplatte (9) aufweist, die in eine schräge Position zu der ersten Fließrichtung (2) angeordnet ist, um den Querschnittsbereich des Flusses aus dem Einlass (1) zu reduzieren, und dass
die Pforte (7), von welcher der zweite Fließkanal (5) beginnt, unmittelbar flussabwärts von der Führungsplatte (9) angeordnet ist.

6. Die Kühlstruktur gemäß einem der Patentansprüche 1 bis 5, **dadurch gekennzeichnet, dass** die erste Komponente (3) ein Kühlelement ist, mit dessen Hilfe der Fluss elektronische Komponenten im Zusammenhang mit dem Kühlelement (3) abkühlt.

7. Die Kühlstruktur gemäß einem der Patentansprüche 1 bis 6, **dadurch gekennzeichnet , dass** im Zusammenhang mit dem Einlass (1) ein Gebläse (14) zum Erzeugen des besagten Flusses angeordnet ist.

8. Die Kühlstruktur gemäß einem der Patentansprüche 1 bis 6, **dadurch gekennzeichnet, dass** die Kühlstruktur ein oder mehrere Gebläse (14) aufweist, die stromabwärts von der ersten Komponente (3) in dem ersten Fließkanal und von der elektronischen Komponente (8) in dem zweiten Fließkanal (5) zum Erzeugen eines Flusses in dem ersten und dem zweiten Fließkanal angeordnet sind.

9. Die Kühlstruktur gemäß einem der Patentansprüche 1 bis 8, **dadurch gekennzeichnet, dass** die Pforte (7), von welcher der zweite Fließkanal (5) beginnt, eine erste Weite in der ersten Fließrichtung (2) aufweist, welche Weite kleiner als die Länge der Pforte (7) ist, die sich quer zu der ersten Fließrichtung (2) befindet.

10. Ein Verfahren um einen abkühlenden Fluss für eine elektronische Komponente zur Verfügung zu stellen, wobei das Verfahren
einen sekundären Fluss aus einem Hauptfluss mit einer Pforte (7) separiert, welche Pforte (7) quer zu der ersten Fließrichtung (2) oder von der ersten Fließrichtung (2) wegwärts orientiert ist, und
den separierten sekundären Fluss durch einen Komponentenraum (10), welcher eine elektronische Komponente (8) aufweist, an einen Auslass (4) befördert, **dadurch gekennzeichnet , dass** der besagte sekundäre Fluss in den Komponentenraum (10) durch einen Zwischenraum (11) befördert wird, wobei der Komponentenraum von dem Zwischenraum durch eine Trennwand (12) separiert ist, und
die Flussrate des sekundären Flusses in dem Zwischenraum (11) reduziert wird, welcher sich flussaufwärts von dem Komponentenraum (10) befindet, indem der sekundäre Fluss in den Zwischenraum durch eine Pforte (7) befördert wird, deren Flächeninhalt kleiner als der Flächeninhalt der Öffnung (9) ist, durch welche der sekundäre Fluss weiter aus dem Zwischenraum (11) in den Komponentenraum (10) weiterbefördert wird.

## Revendications

1. Structure de refroidissement pour un dispositif électronique, la structure comprenant :
un orifice d'entrée (1) pour recevoir et acheminer un flux plus loin dans une première direction de flux (2) vers un premier composant (3) situé dans un premier canal de flux ;
un orifice de sortie (4) pour acheminer le flux plus loin à partir du premier composant (3) situé dans le premier canal de flux ; et
un second canal de flux (5), qui part d'un orifice (7) orienté de manière transversale par rapport à la première direction de flux (2) ou en s'éloignant de la première direction de flux (2), qui se situe dans le flux en amont du premier composant (3) et reçoit une partie du flux en provenance de l'orifice d'entrée (1) et qui achemine ladite partie du flux vers un composant électronique (8) situé dans le second canal de flux (5), **caractérisée en ce que** :
le second canal de flux (5) comprend un espace intermédiaire (11) et un espace de composant (10) séparés l'un de l'autre par une cloison de séparation (12) ;
l'espace intermédiaire (11) situé au début du second canal de flux (5) communique avec l'espace de composant (10) à travers une ouverture (13) dans la cloison de séparation (12) ; et
la surface de l'orifice (7), à travers lequel le flux pénètre dans l'espace intermédiaire (11) est plus petite que la surface de l'ouverture (13) dans la cloison de séparation (12), à travers laquelle le flux passe dans l'espace de composant (10) à partir de l'espace intermédiaire (11).

2. Structure de refroidissement selon la revendication 1, **caractérisée en ce que** :
le second canal de flux (5) est majoritairement parallèle au premier canal de flux, et **en ce que**
les premier et second canaux de flux présentent un orifice de sortie (4) commun pour acheminer le flux plus loin à partir des premier et second canaux de flux.

3. Structure de refroidissement selon l'une quelconque des revendications 1 ou 2, **caractérisée en ce que** l'orifice (7), à partir duquel commence le second canal de flux (5), se situe à proximité d'un point où la superficie en coupe transversale du flux à partir de l'orifice d'entrée change.

4. Structure de refroidissement selon la revendication 3, **caractérisée en ce que** l'orifice (7), à partir duquel commence le second canal de flux (5), se situe à un endroit où la réduction de la surface en coupe transversale du flux à partir de l'orifice d'entrée (1) se termine.

5. Structure de refroidissement selon l'une quelconque des revendications 1 ou 2, **caractérisée en ce que** :
la structure de refroidissement comprend une plaque de guidage (9) qui est agencée dans une position oblique par rapport à la première direction de flux (2) de façon à réduire la surface en coupe transversale du flux à partir de l'orifice d'entrée (1), et **en ce que**
l'orifice (7), à partir duquel commence le second canal de flux (5), est agencé immédiatement en aval de la plaque de guidage (9).

6. Structure de refroidissement selon l'une quelconque des revendications 1 à 5, **caractérisée en ce que** le premier composant (3) est un élément de refroidissement, au moyen duquel le flux refroidit des composants électroniques en association avec l'élément de refroidissement (3).

7. Structure de refroidissement selon l'une quelconque des revendications 1 à 6, **caractérisée en ce que**, pour générer ledit flux, un ventilateur (14) est agencé en association avec l'orifice d'entrée (1).

8. Structure de refroidissement selon l'une quelconque des revendications 1 à 6, **caractérisée en ce que** la structure de refroidissement comprend un ou plusieurs ventilateurs (14) agencés en aval du premier composant (3) dans le premier canal de flux et du composant électronique (8) dans le second canal de flux (5), respectivement, de façon à générer un flux dans les premier et second canaux de flux.

9. Structure de refroidissement selon l'une quelconque des revendications 1 à 8, **caractérisée en ce que** l'orifice (7), à partir duquel commence le second canal de flux (5), présente une première largeur dans la première direction de flux (2) qui est plus petite que la longueur de l'orifice (7) transversalement à la première direction de flux (2).

10. Procédé destiné à fournir un flux de refroidissement pour un composant électronique, le procédé :
séparant un flux secondaire d'un flux principal avec un orifice (7) orienté transversalement par rapport à la première direction de flux (2) ou en s'éloignant de la première direction de flux ; et
acheminant le flux secondaire séparé vers un orifice de sortie (4) à travers un espace de composant (10) recevant un composant électronique (8), **caractérisé en ce que** ledit flux secondaire est acheminé jusque dans l'espace de composant (10) à travers un espace intermédiaire (11), l'espace de composant étant séparé de l'espace intermédiaire par une cloison de séparation (12) ; et
réduisant le débit du flux secondaire dans l'espace intermédiaire (11) qui se situe en amont de l'espace de composant (10) en acheminant le flux secondaire jusque dans l'espace intermédiaire à travers un orifice (7) dont la surface est plus petite que la surface d'une ouverture (13) à travers laquelle le flux secondaire est acheminé plus loin vers l'espace de composant (10) à partir de l'espace intermédiaire (11).
